# EUROPÄISCHE PATENTSCHRIFT

(11) **EP 2 010 693 B1**
(45) Veröffentlichungstag und Bekanntmachung des Hinweises auf die Patenterteilung: **28.03.2012**
(21) Anmeldenummer: 07728168.1
(22) Anmeldetag: 17.04.2007
(51) Int. Cl.: C23C 16/44, C23C 16/46, C23C 16/455

(54) **CVD-REAKTOR MIT ABSENKBARER PROZESSKAMMERDECKE**
CVD REACTOR HAVING A PROCESS CHAMBER LID WHICH CAN BE LOWERED
REACTEUR A CVD AVEC COUVERCLE DE CHAMBRE DE TRAITEMENT ABAISSABLE

(30) Priorität: 21.04.2006 DE 102006018515
(43) Veröffentlichungstag der Anmeldung: 07.01.2009
(73) Patentinhaber: Aixtron SE, 52134 Herzogenrath (DE)
(72) Erfinder: DAUELSBERG, Martin, 52074 Aachen (DE); KÄPPELER, Johannes, 52146 Würselen (DE); SCHULTE, Bernd, 52066 Aachen (DE)
(74) Vertreter: Rieder, Hans-Joachim
(86) Internationale Anmeldenummer: PCT/EP2007/053703
(87) Internationale Veröffentlichungsnummer: WO 2007/122137

(56) Entgegenhaltungen:
- US-A1- 2006 051 966
- US-B1- 6 705 394

## Beschreibung

Die Erfindung betrifft eine Vorrichtung zum Abscheiden einer oder mehrerer Schichten auf einem Substrat mit einer in einem Reaktorgehäuse angeordneten Prozesskammer, die einen beheizbaren Boden, auf dem das Substrat liegt, und eine sich parallel zum Boden erstreckende Decke sowie ein Gaseinlassorgan zum Einleiten von Prozessgäsen aufweist, wobei der Abstand der Prozesskammerdecke zum Prozesskammerboden von einer Prozessstellurig, in welcher die Schichten auf dem Substrat abgeschieden werden, in eine Reinigungsstellung, in welcher die Prozesskammer gereinigt wird, bis auf Null reduzierbar ist.

Eine derartige Vorrichtung ist aus der US 2006/0051966 A1 vorbekannt. Ein Boden einer Prozesskammer kann aufgeheizt werden. Oberhalb des Prozesskammerbodens befindet sich eine Prozesskammerdecke. In einer Prozessstellung, in welcher Prozessgase in die Prozesskammer eingeleitet werden, so dass auf sich dort befindlichen Substraten Schichten abgeschieden werden, besitzt die Prozesskammer eine erste Höhe, die durch den Abstand von Prozesskammerboden und Prozesskammerdecke definiert ist. Durch Anheben des Prozesskammerbodens kann der Abstand zwischen Prozesskammerdecke und Prozesskammerboden vermindert werden. In dieser verminderten Abstandsstellung nimmt die Prozesskammer eine Ätzstellung ein, in welcher durch Einleiten eines Ätzgases die Prozesskammer gereinigt werden kann.

Aus der DE 101 03 341 A1 ist eine Plasmabehandlungsvorrichtung vorbekannt, bei der der Abstand zwischen Prozesskammerdecke und Prozesskammerboden variierbar ist.

Die WO 03/063216 A1, US 5,399,387, US 2005/0199182 A1, WO 00/42236, US 2003/0000469 A1, US 2005/0242061 A1 sowie JP 05029302 A beschreiben ebenfalls Abscheidevorrichtungen zum Abscheiden von Schichten auf Substraten in einer Prozesskammer, bei denen die Prozesskammerhöhe variierbar ist.

Die DE 102 11 442 A1 beschreibt einen CVD-Reaktor mit einem Reaktorgehäuses und einem in dem Reaktorgehäuses angeordneten Gaseinlassorgan. Durch dieses Einlassorgan werden Prozessgase in eine Prozesskammer eingeleitet. Die Prozesskammer besitzt eine Decke und einen Boden. Auf dem Boden liegen die Substrate. Der Boden wird von unten beheizt. Die Decke erstreckt sich in Horizöntallage parallel mit Abstand zum Boden. Dort liegt das Gaseinlassorgan oberhalb der Reaktordecke. Letzte weist duschkopfartige Gasaustrittsöffnungen auf, durch welche die Prozessgase in die Prozesskammer eintreten können.

Aus der DE 101 33 914 A1 ist ein CVD-Reaktor bekannt, bei dem die Prozessgase in das Zentrum der Prozesskammer eingeleitet werden. Es durchströmt die Prozesskammer in radialer horizontaler Richtung. Die Prozesskammer ist von einem Gasauslassring umgeben, mittels welchem das Prozessgas abtransportiert wird.

Der Erfindung liegt die Aufgabe zugrunde, die gattungsgemäße Vorrichtung zur Durchführung eines Kalt-Wänd-Beschichhingsprozesses, bei dem die Prozesskammerdecke aktiv gekühlt werden muss, weiterzubilden.

Gelöst wird die Aufgabe durch die in den Ansprüchen angegebene Erfindung.

Erfindungsgemäß ist der Abstand der Prozesskammerdecke zum Prozesskammerboden zur Erreichung einer Reinigungsstellung bis auf Null reduzierbar. Dabei wird lediglich der Boden der Prozesskammer beheizt. Die Prozesskammerdecke wird während des Abscheideprozesses aktiv gekühlt. Hierzu ist ein Kühlaggregat vorgesehen, welches oberhalb der Prozesskammerdecke im Reaktorgehäuse angeordnet ist und welches ortsfest im Reaktor angeordnet sein kann. Beim Absenken der Prozesskammerdecke in Richtung auf den Prozesskammerboden vergrößert sich der Abstand zwischen der Rückseite und dem Kühlaggregat, so dass die kühlende Wirkung des Kühlaggregats in Bezug auf die Prozesskammerdecke drastisch reduziert wird. Während des Reinigungsprozesses, bei dem es sich bevorzugt um einen Ätzprozess handelt, braucht somit lediglich die Prozesskammerdecke abgesenkt zu werden. In vorteilhafter Weise sind Mittel vorgesehen, die in der Prozessstellung das Kühlaggregat in berührender Anlage an der Rückseite der Prozesskammerdecke halten. Es kann sich dabei um eine großflächige Flächenanlage zwischen einer Kühloberfläche des Kühlaggregates und der Rückseite der Prozesskammerdecke handeln. Damit lassen sich Probleme lösen, die beim Abscheiden von Schichten im Kalt-Wand-Reaktor auftreten, also insbesondere bei Problemen im MOCVD-Prozess. Beim Abscheiden von Schichten auf einem auf dem Boden der Prozesskammer liegenden Substrat werden die Prozessgase pyrolytisch umgesetzt. Der dabei entstehende Feststoff kristallisiert auf dem Substrat. Parasitäres Wachstum auf der das Substrat umgebenden Oberfläche des Bodens der Prozesskammer, die einen Suszeptor ausbildet, ist nicht zu vermeiden. Obwohl die Decke des Reaktors gekühlt ist, ist auch dort parasitäres Wachstum nicht zu vermeiden. Die durch parasitäres Wachstum entstandenen Verunreinigungen bilden Konsumierungsflächen für das in die Prozesskammer eingebrachte Prozessgas. Dies vermindert die Effizienz des Prozesses und beeinträchtigt das Wachstumsverhalten der auf den Substraten abzuscheidenden Schichten. Es ist deshalb erforderlich, die Prozesskammer und insbesondere die durch parasitäres Wachstum beeinträchtigten Oberflächen zu reinigen. Eine aufwendige Methode besteht darin, die entsprechenden Teile des Reaktors aus dem Reaktor herauszunehmen und getrennt vom Reaktor zu reinigen. Derartige Prozesskammern besitzen einen auswechselbaren Prozesskammerboden und eine auswechselbare Prozesskammerdecke. Eine Alternative dazu ist die In-Situ-Reinigung durch Einleiten eines geeigneten Ätzgases. In Betracht kommt hier HCl. Dieser Prozess setzt aber auch eine bestimmte Oberflächentemperatur der zu ätzenden Flächen voraus. Es ist in der Regel unproblematisch, den geheizten Prozesskammerboden auf die erforderliche Ätztemperatur aufzuheizen. Bei einer gekühlten Prozesskammerdecke ist dies problematisch, da diese im Wesentlichen nur durch die vom Prozesskammerboden ausgehende Strahlung erwärmbar ist. Zufolge der in den Ansprüchen angegebenen technischen Lehre ist dieses Problem behoben. Die Prozesskammerdecke wird zur Durchführung des Ätzprozesses bis nahe an den Prozesskammerboden abgesenkt. Alternativ dazu kann aber auch der Prozesskammerboden bis nahe an die Prozesskammerdecke angehoben werden. Ein die Prozesskammerdecke kühlendes Kühlorgan kann bei dieser Vertikalverlagerung entweder der Decke oder des Bodens seinen Abstand zum Boden beibehalten, so dass eine effektive Beabstandung der Prozesskammerdecke vom Kühlaggregat erfolgt. Alternativ dazu könnte das Kühlorgan aber auch zusätzlich noch von der Prozesskammerdecke entfernt werden. Das Kühlaggregat besitzt bevorzugt eine nach unten in Richtung auf den Boden weisende Horizontalfläche. Diese Horizontalfläche verläuft parallel zu einer Rückseitenfläche der Prozesskammerdecke. Diese wird von einer Deckenplatte gebildet. Die Deckenplatte liegt vorzugsweise in berührender Anlage an dem Kühlaggregat. Es kann eine Boden- oder Deckenhalterung vorgesehen sein, um die Decke bzw. den Boden der Prozesskammer innerhalb des Reaktorgehäuses zu halten. Eine oder beide dieser Halterungen können vertikal verlagert werden, so dass der Abstand zwischen Decke und Boden der Prozesskammer zum Zwecke des Ätzens letzterer vermindert werden kann. Die Deckenplatte kann kreisrund sein. Sie kann aber auch einen kreisscheibenförmigen Grundriss aufweisen. Der Innenrand dieser kreisscheibenförmigen Deckenplatte liegt bevorzugt auf Haltemitteln eines Innenzylinders. Letzterer ist mit Hubmitteln absenkbar. Die Hubmittel können im Zentrum der Deckenplatte angeordnet sein. Des Weiteren kann sich im Zentrum der Prozesskammer ein Gaseinlassorgan befinden. Dieses wird bevorzugt von unten her mit den Prozessgasen gespeist. Das Gaseinlassorgan kann eine Vielzahl von voneinander getrennten Kanälen aufweisen, durch die die Prozessgase in die Prozesskammer eingeleitet werden. Die den einzelnen Kanälen zugeordneten Austrittsöffrungen können jeweils auf einer Zylindermantelfläche liegen. Somit ist eine Rotationssymmetrie der Gasaustrittsflächen gegeben, die insgesamt übereinander angeordnet sind. Beim Vermindern des Abstandes zwischen Prozesskammerdecke und Prozesskammerboden werden die Austrittsöffnungen der Prozessgase teilweise von der Innenwandung des Innenzylinders überdeckt. Das zum Ätzen der Prozesskammer verwendete HCl kann somit durch diese zentralen Zuleitungen, also über das Gaseinlassorgan, in die Prozesskammer eingeleitet werden. Vorzugsweise tritt das Ätzgas aus der zuoberst liegenden Gasaustrittsöffnung aus und streicht dann an der Innenwandung des Innenzylinders vorbei. Es wird dann in die Horizontalrichtung umgelenkt und durchströmt die höhenverminderte Prozesskammer, wobei sowohl der Boden als auch die Decke der Prozesskammer geätzt werden. In einer Variante ist vorgesehen, dass das Gaseinlassorgan von der Decke der Prozesskammer selbst gebildet wird. Letztere bildet dann eine Gasaustrittsfläche aus. Die Gasaustrittsfläche besitzt eine Vielzahl von duschkopfartig angeordneten Gasaustrittsöffnungen. Auch eine derartige Prozesskammer ist von einem Gassammelring umgeben. Oberhalb der Decke befindet sich ein in der Regel wassergekühlter duschkopfartiger Körper mit einem Gasplerium, mit welchem die Gasaustrittsöffnungen gasversorgt werden. Durch dieses Plenum kann im Bedarfsfall auch das Ätzgas in die Prozesskammer eingeleitet werden. Bevorzugt besitzt die Prozesskammer jedoch eine zentrale gesonderte Zuleitung durch den Boden der Prozesskammer, durch welche das Ätzgas in die Prozesskammer eingeleitet wird.

Ausführungsbeispiele der Erfindung werden nachfolgend anhand beigefügter Zeichnungen erläutert. Es zeigen:
- Fig. 1: den Halbquerschnitt eines Reaktorgehäuses des ersten Ausführungsbeispiels mit in Prozessstellung befindlicher Deckenplatte;
- Fig. 2: eine Darstellung gemäß Fig. 1 mit in der Ätzstellung abgesenkter Deckenplatte;
- Fig. 3: den Schnitt durch ein Reaktorgehäuse eines zweiten Ausführungsbeispiels in der Prozessstellung; und
- Fig. 4: eine Darstellung gemäß Fig. 3 mit in die Ätzstellung abgesenkter Dekkenplatte.

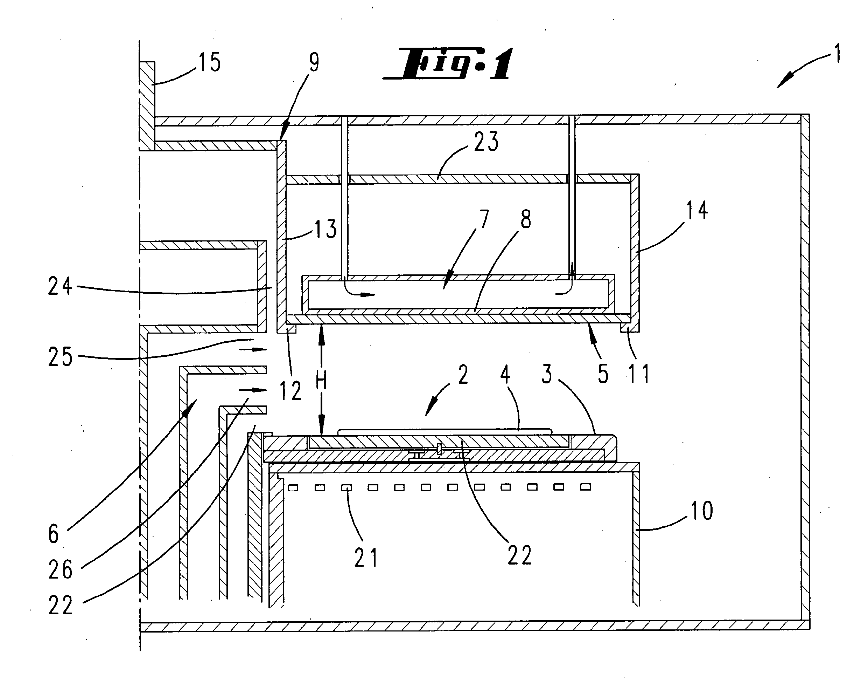

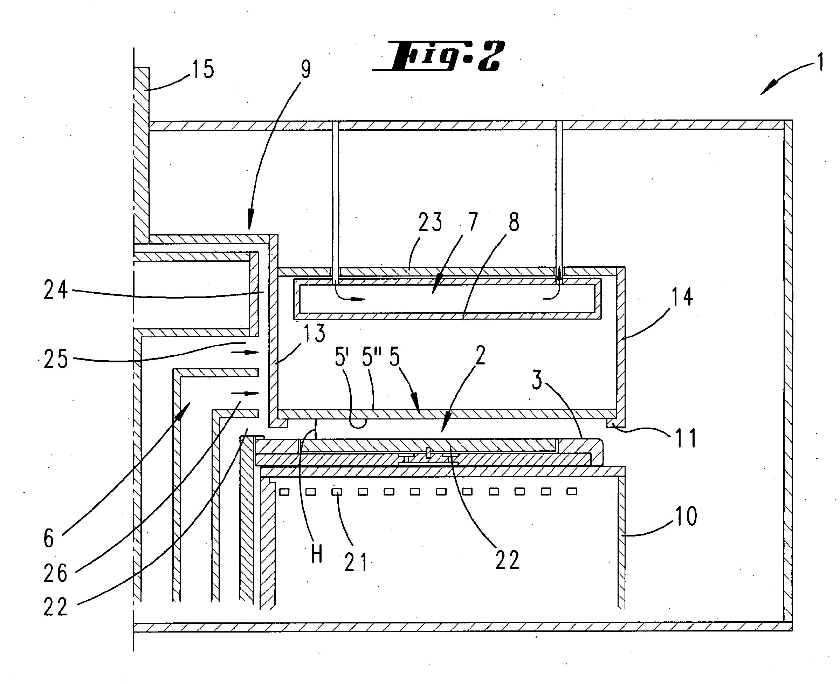

In den Figuren 1 und 2 ist grobschematisch der Aufbau eines Reaktorgehäuses 1 dargestellt. Letzteres besitzt einen Boden 3, der aus Graphit oder einem anderen geeigneten Material, bspw. Saphir oder Quarz bestehen kann. Der Boden 3 liegt auf einem Bodenträger. Unterhalb des Bodenträgers befindet sich eine Heizung 21. Es kann sich um eine RF-Heizung oder um eine Widerstandsheizung handeln. Mit dieser wird der Boden 3 auf die Prozesstemperatur aufgeheizt. Der Boden wird von einer Bodenhalterung 10 getragen.

Oberhalb des Bodens befindet sich in einem Abstand H die Decke 5 der Prozesskammer. Die Decke 5 besteht aus einer kreisringförmigen Scheibe 5, aus Quartz, Saphir, Graphit oder einem anderen geeigneten Material. Diese Decke liegt in der in Fig. 1 dargestellten Prozessstellung in berührender Anlage an einer Kühlfläche 8, die die Unterseite eines Kühlaggregates 7 ist. Boden 3 und Decke 5 können beschichtet sein.

Das Kühlaggregat 7 ist ein Hohlkörper, der von einer Kühlflüssigkeit durchströmt ist. Das Kühlaggregat 7 ist ortsfest mit dem Reaktorgehäuse 1 verbunden. Der Innenrand der Deckenplatte 5 liegt auf einem Kragen 12 eines Innenzylinders 13 auf. Dieser Innenzylinder 13 ist Teil einer Deckenhalterung 9, die mit einem Hubmittel 15 in Vertikalrichtung verlagerbar ist. Zur Deckenhalterung 9 gehört darüber hinaus ein Außenzylinder 14, der einen nach innen gerichteten Kragen 12 ausbildet, auf dem der äußere Rand der Deckenplatte 5 aufliegt. Der Außenzylinder 14 ist mittelst einer Querverbindung 23 mit dem Innenzylinder 13 verbunden, so dass Außenzylinder 14 und Innenzylinder 13 abgesenkt werden können. Beim Absenken von Außenzylinder 14 und Innenzylinder 13 wird die Prozesskammerdecke 5 von der Kühlfläche 8 beabstandet. Sie nähert sich dabei unter gleichzeitiger Verminderung des Abstandes H einem Suszeptor 22 an, der Teil des Bodens 3 ist und auf dem während des Prozessschrittes das Substrat 4 angeordnet ist.

Das Hubmittel 15 ist in den Zeichnungen nur schematisch dargestellt. Es kann sich um einen Pneumatikzylinder handeln. Denkbar ist auch die Verwendung eines Zahnstangen- oder Hebelgetriebes.

Die in Fig. 1 dargestellte Prozesskammer 2 besitzt eine kreisringförmige Gestalt. Im Zentrum der Prozesskammer 2 befindet sich ein Gaseinlassorgan 6 zum Einleiten der Prozessgase. Die Prozessgase können metallorganische Verbindungen sein, die ein Element der III. Hauptgruppe in die Prozesskammer transportieren. Elemente der V. Hauptgruppe werden in Form von Hydriden in die Prozesskammer eingeleitet. Es ist aber auch möglich, die Elemente der III. Hauptgruppe in Form von Chloriden in die Prozesskammer einzuleiten. Die einzelnen Prozessgase werden getrennt voneinander durch Gasauslässe 25, 26, 27, die übereinander angeordnet sind, in die Prozesskammer 2 eingeleitet. Dies erfolgt rotationssymmetrisch. Ein sich oberhalb der Gasauslässe 25, 26, 27 erstreckender Spalt 24 zwischen Innenzylinder 13 und oberem Teil des Gaseinlassorgans 6 wird mit einem Inertgas gespült. Während des Beschichtungsprozesses wird der in einer Aussparung der Bodenplatte 3 einliegende kreisscheibenförmige Suszeptor 22 gedreht.

Zur Durchführung des Ätzprozesses, bei dem sich kein Substrat 4 in der Prozesskammer 2 befindet, wird mittelst des schematisch dargestellten Hubmittels 15 die Deckenhalterung 9 abgesenkt. Die jetzt von dem Kühlaggregat 7 entfernte Deckenplatte 5 kann sich zufolge der auf sie einwirkenden Wärmestrahlung vom Boden 3 her aufheizen. Durch das Gaseinlassorgan 6 wird ein Ätzgas, bspw. HCl in die Prozesskammer geleitet. Dies erfolgt bevorzugt durch die zuoberst liegende Gasaustrittsöffnung 25, so dass das Ätzgas an der Innenwandung des Innenzylinders 13 vertikal abwärts strömt, bevor es in die Horizontalrichtung umgeleitet wird und über den Boden 3 und an der Unterseite 5' der Decke 5 entlang strömt. Dabei werden die aufeinander zuweisenden Oberflächen vom Boden 3 und Decke 5 geätzt. Hierdurch wird beim Wachstumsprozess zufolge parasitären Wachstums dort abgeschiedenes Material entfernt.

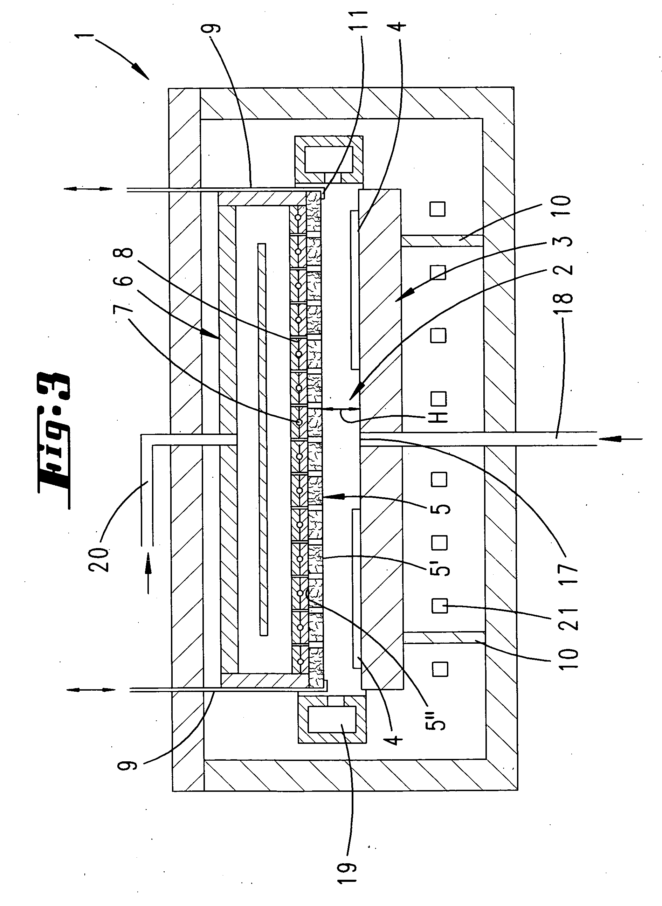

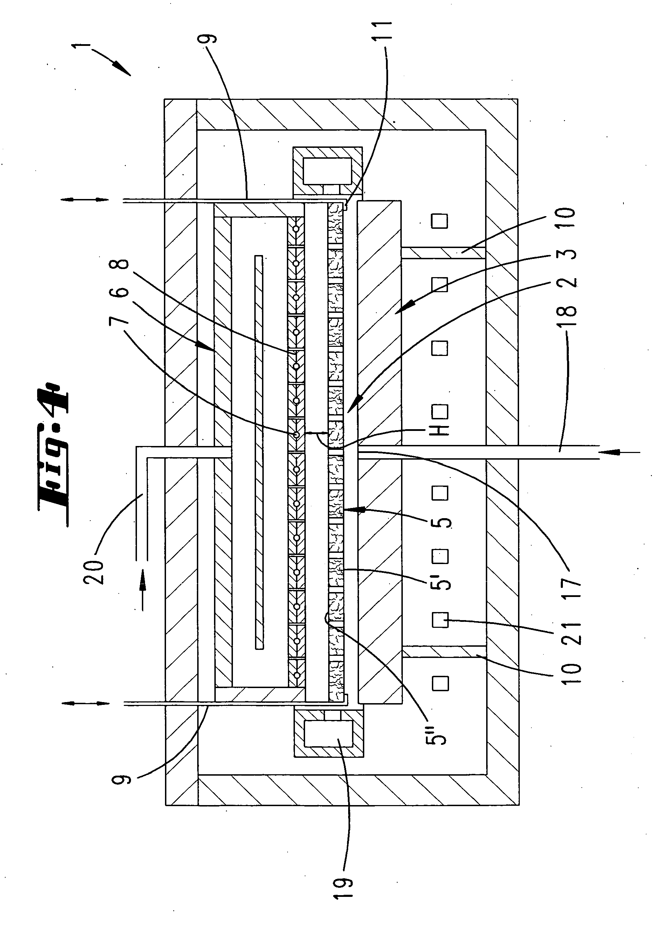

In den Figuren 3 und 4 ist ein sogenannter Showerhead-Reaktor dargestellt. Auch hierbei handelt es sich um einen CVD-Reaktor, bei dem mittels in die Prozesskammer 2 eingeleiteter Prozessgase Schichten auf Substraten 4 abgeschieden werden. Hier erstreckt sich das Gaseinlassorgan 6 über die gesamte Grundfläche der Prozesskammer. Das Gaseinlassorgan 6 besitzt ein Gasplenum, welches an seiner Unterseite Gasaustrittsöffnungen aufweist. Die Unterseite des Gaseinlassorgans 6 ist eine Kühlfläche 8. Sie wird mittelst Kühlmittel gekühlt. Unterhalb dieser Kühlfläche 8 befindet sich eine Deckenplatte 5. Letztere besitzt eine Vielzahl siebartig angeordneter Gasaustrittsöffnungen, die mit Gasaustrittsöffnungen der Kühlfläche 8 fluchten, so dass das durch einen Gaseinlass 20 in das Gaseinlassorgan 6 eingebrachte Gas durch die Gasaustrittsöffnungen 16 in die Prozesskammer 2 strömen kann.

In der in Fig. 3 dargestellten Prozessstellung liegt die aus Graphit, Quarz, Saphir oder einem anderen geeigneten wärmeleitenden oder wärmeisolierenden Material bestehende Deckenplatte 5 in berührender Anlage an der Kühlfläche 8.

Die Deckenplatte 5 ruht hierzu auf Haltevorsprüngen 11, die von einer Deckenhalterung 9 ausgebildet werden. Die Deckenhalterung 9 ist absenkbar, so dass die Deckenplatte 5 der Oberfläche des Bodens 3 angenähert werden kann.

Der Boden 3 ruht auf einer Bodenhalterung 10. Unterhalb des Bodens 3 befindet sich eine Heizung 21, mit der der Boden beheizt werden kann. Der Boden besteht aus Graphit, Quarz, Saphir oder einem anderen geeigneten Material, damit die auf dem Boden 3 aufliegenden Substrate 4 erwärmt werden können.

Die Prozesskammer ist von einem ringförmigen Gasauslassring 19 umgeben, mit dem das nicht verbrauchte Prozessgas oder Reaktionsprodukte abgeleitet werden können.

Nach Durchführung des Beschichtungsprozesses und Entnahme der Substrate 4 aus der Prozesskammer 2 kann die Deckenhalterung 9 mittelst einer nicht dargestellten Hubeinrichtung abgesenkt werden. Dabei vermindert sich der Abstand H zwischen Boden 3 und Decke 5. Gleichzeitig vergrößert sich der Abstand der Decke 5 von der Kühlfläche 8, so dass sich die Decke 5 derartig aufheizen kann, dass dort abgeschiedenes Material durch Einleiten eines Ätzgases entfernt werden kann.

Das Ätzgas, bei dem es sich auch hier vorzugsweise um ein Chlorid und insbesondere HCl handelt, kann durch das Gaseinlassorgan, also durch den Gaseinlass 20 in die Prozesskammer eingeleitet werden. Im Ausführungsbeispiel ist jedoch eine Zuleitung 18 durch den Boden 3 vorgesehen, durch welche Zuleitung 18 das Ätzgas in das Zentrum der Prozesskammer eingebracht werden kann.

Auch bei dem in den Figuren 3 und 4 dargestellten Ausführungsbeispiel können die Substrate 4 auf drehbaren Suszeptoren aufliegen. Auch hier kann der Boden 3 insgesamt um seine Achse gedreht werden.

In den beiden zuvor beschriebenen Ausführungsbeispielen wurde zum Zwecke der Abstandsverminderung zwischen Decke 5 und Boden 3 die Deckenplatte abgesenkt. Es ist jedoch gleichfalls möglich, in beiden Ausführungsbeispielen durch eine entsprechende Gestaltung der Bodenhalterung 10 den Boden 3 an die Decke 5 anzunähern. Bevorzugt wird bei dieser Annäherung aber ein Kühlaggregat 7 oder eine Kühlfläche 8 von der Deckenplatte 5 distanziert. Das Hubmittel zum Anheben des Bodens 3 kann somit gleichzeitig das Kühlaggregat 7 bzw. die Kühlfläche 8 anheben. Der Abstand der Kühlfläche 8 bzw. Kühlaggregat 7 zum Boden 3 kann bei einer derartigen Vertikalverlagerung unverändert bleiben.

Als besonders vorteilhaft wird es angesehen, dass das Kühlaggregat 7 ortsfest im Reaktorgehäuse angeordnet ist. Sein Abstand zum Boden 3 der Prozesskammer kann somit fest sein. Dieser Abstand braucht nicht geändert zu werden, wenn die Prozesskammerdecke 5 von einer in der Fig. 1 bzw. in der Fig. 3 dargestellten Prozessstellung in eine in der Fig. 2 bzw. in der Fig. 4 dargestellten Reinigungsstellung abgesenkt wird. In beiden Zellen vermindert sich der Abstand H zwischen Prozesskammerboden 3 und Prozesskammerdecke 5. In gleicher Weise vergrößert sich aber der Abstand zwischen der auf die Rückseite 5" der Prozesskammerdecke 5 weisenden Kühlfläche des Kühlaggregates 8. In den in den Figuren 1 und 3 dargestellten Prozessstellungen liegt die ebene Kühlfläche des Kühlaggregates 7 flächig auf der Rückseite 5" der Decke an. Hierdurch ist eine optimale Wärmeabfuhr von der Decke 5 gewährleistet. Die Wärme wird mittels der Kühlflüssigkeit abtransportiert, die durch das Kühlvolumen 7 des Kühlaggregates 8 hindurchströmt. Da sich die Kühlflächenanlage über nahezu die gesamte Flächenerstreckung der Decke 5 erstreckt, kann ein Kalt-Wand-Wachstumsprozess in der Prozesskammer 2 durchgeführt werden. Gleichwohl ist es möglich, ohne das Kühlaggregat 8 außer Betrieb zu setzen, in der in den Figuren 2 bzw. 4 dargestellten Stellung parasitäre Belegungen von der Prozesskammerdecke wegzuätzen. In dieser Reinigungsstellung ist der Abstand H der Decke 5 zum Boden 3 der Prozesskammer 2 geringer als der Abstand der Rückseite 5" der Prozesskammerdecke 5 von der Kühlfläche 8 des Kühlaggregates 7.

## Patentansprüche

1. Vorrichtung zum Abscheiden einer oder mehrerer Schichten auf einem Substrat (4) mit einer in einem Reaktorgehäuse (1) angeordneten Prozesskammer (2), die einen beheizbaren Boden (3), auf dem das Substrat liegt, und eine sich parallel zum Boden (3) erstreckende Decke (5) sowie ein Gaseinlassorgan (6) zum Einleiten von Prozessgasen aufweist, wobei der Abstand (H) der Prozesskammerdecke (5) zum Prozesskammerboden (3) von einer Prozessstellung, in welcher die Schichten auf dem Substrat abgeschieden werden, in eine Reinigungsstellung, in welcher die Prozesskammer gereinigt wird, bis auf Null reduzierbar ist, **gekennzeichnet durch** ein oberhalb der Prozesskammerdecke (5) angeordnetes Kühlaggregat (7), mit welchem die Prozesskammerdecke (5) in der Prozessstellung beim Abscheiden der Schichten gekühlt wird, wobei sich der Abstand des Kühlaggregates (7) zur Prozesskammerdecke (5) bei der Reduzierung des Abstandes (H) der Prozesskammerdecke (5) zum Prozesskammerboden (3) vergrößert.

2. Vorrichtung nach Anspruch 1, **dadurch gekennzeichnet, dass** das Kühlaggregat (7) eine sich parallel zur Rückseite (5") der Decke (5) erstreckende Kühlfläche (8) aufweist.

3. Vorrichtung nach Anspruch 1 , **dadurch gekennzeichnet, dass** die Kühlfläche (8) in der Prozessstellung in berührender Anlage an der Rückseite (5") der Decke (5) anliegt.

4. Vorrichtung nach einem der vorhergehenden Ansprüche , **gekennzeichnet durch** eine sich über im Wesentlichen die gesamte Rückseite (5") der Decke (5) erstreckende, in Wärmeleitungsanlage an der Decke (5) anliegende Kühlfläche (8) des Kühlaggregates (7).

5. Vorrichtung nach einem der vorhergehenden Ansprüche , **dadurch gekennzeichnet, dass** das Kühlaggregat (7) von einer Kühlflüssigkeit durchströmte Hohlkörper ausbildet.

6. Vorrichtung nach einem der vorhergehenden Ansprüche , **gekennzeichnet durch** eine in Vertikalrichtung innerhalb des Reaktorgehäuses verlagerbare Boden- oder Deckenhalterung (9,10).

7. Vorrichtung nach einem der vorhergehenden Ansprüche , **gekennzeichnet durch** am Rand der Decke (5) angreifende Haltemittel (11, 12) der Deckenhalterung (9).

8. Vorrichtung nach einem der vorhergehenden Ansprüche , **gekennzeichnet durch** eine kreisringscheibenförmige Deckenplatte (5), deren Innenrand auf Haltemitteln (12) eines Innenzylinders (13) der Deckenhalterung (9) aufliegt.

9. Vorrichtung nach einem oder mehreren der vorhergehenden Ansprüche , **dadurch gekennzeichnet dass** der Außenrand den Deckenplatte (5) auf Haltemitteln (11) eines Außenzylinders (14) der Deckenhalterung (9) liegt.

10. Vorrichtung nach einem der vorhergehenden Ansprüche, **gekennzeichnet durch** oberhalb der Prozesskammer(2) angeordnete Hubmittel (15) zur Vertikalverlagerung des Deckenhalters (9).

11. Vorrichtung nach einem der vorhergehenden Ansprüche, **gekennzeichnet durch** ein von unten **durch** den Boden (3) in die Prozesskammer (2) ragendes Gaseinlassorgan (6), das in abgesenkter Stellung der Decke (5) vom Innenzylinder (13) zumindest teilweise überrangen ist.

12. Vorrichtung nach einem der vorhergehenden Ansprüche, **dadurch gekennzeichnet, dass** die Decke (5) die Gasaustrittsfläche eines Gaseinlassorgans (6) ausbildet mit duschkopfartig angeordneten Gasaustrittsöffnungen (16).

13. Vorrichtung nach einem der vorhergehenden Ansprüche, **gekennzeichnet durch** eine dem Boden (3) zugeordnete Gasaustrittsöffnung (17) für ein Ätzgas.

## Claims

1. Apparatus for depositing one or more layers on a substrate (4), having a process chamber (2) which is disposed in a reactor housing (1) and has a heatable floor (3), on which the substrate rests, and a ceiling (5), extending parallel to the floor (3), and also a gas-inlet means (6) for introducing process gases, it being possible for the distance (H) between the process-chamber ceiling (5) and the process-chamber floor (3) to be reduced to zero from a process position, in which the layers are deposited on the substrate, to a cleaning position, in which the process chamber is cleaned, **characterized by** a cooling assembly (7) which is disposed above the process-chamber ceiling (5) and by means of which the process-chamber ceiling (5), in the process position, is cooled as the layers are deposited, the distance between the cooling assembly (7) and the process-chamber ceiling (5) increasing as the distance (H) between the process-chamber ceiling (5) and the process-chamber floor (3) decreases.

2. Apparatus according to Claim 1, **characterized in that** the cooling assembly (7) has a cooling surface (8) extending parallel to the rear side (5") of the ceiling (5).

3. Apparatus according to claim 1, **characterized in that** the cooling surface (8), in the process position, rests in abutting contact against the rear side (5") of the ceiling (5).

4. Apparatus according to one of the preceding claims, **characterized by** a cooling surface (8) of the cooling assembly (7) which extends over substantially the entire rear side (5") of the ceiling (5) and rests in thermally conductive abutment against the ceiling (5).

5. Apparatus according to one of the preceding claims, **characterized in that** the cooling assembly (7) forms hollow bodies through which a cooling liquid flows.

6. Apparatus according to one of the preceding claims or in particular according thereto, **characterized by** a floor or ceiling holder (9, 10) which can be displaced in the vertical direction within the reactor housing.

7. Apparatus according to one of the preceding claims, **characterized by** retaining means (11, 12) of the ceiling holder (9) which act on the edge of the ceiling (5).

8. Apparatus according to one of the preceding claims, **characterized by** an annular ceiling panel (5), the inner edge of which rests on retaining means (12) of an inner cylinder (13) of the ceiling holder (9).

9. Apparatus according to one or more of the preceding claims, **characterized in that** the outer edge of the ceiling panel (5) rests on retaining means (11) of an outer cylinder (14) of the ceiling holder (9).

10. Apparatus according to one of the preceding claims, **characterized by** lifting means (15) which are disposed above the process chamber (2) and are intended for displacing the ceiling holder (9) vertically.

11. Apparatus according to one of the preceding claims, **characterized by** a gas-inlet means (6) which projects through the floor (3) into the process chamber (2) from beneath and, in the lowered position of the ceiling (5), is covered over, at least in part, by the inner cylinder (13).

12. Apparatus according to one of the preceding claims, **characterized in that** the ceiling (5) forms the gas-outlet surface of a gas-inlet means (6), with gas-outlet openings (16) disposed in the manner of a shower head.

13. Apparatus according to one of the preceding claims, **characterized by** a gas-outlet opening (17) which is associated with the floor (3) and is intended for an etching gas.

## Revendications

1. Dispositif de dépôt d'une ou de plusieurs couches sur un substrat (4), ledit dispositif comportant une chambre de réaction (2) qui est disposée dans un boîtier de réacteur (1) et qui comporte un fond (3), qui peut être chauffé et sur lequel repose le substrat, et un couvercle (5), qui s'étend parallèlement au fond (3), ainsi qu'un organe d'admission de gaz (6) destiné à injecter des gaz de réaction, la distance (H) du couvercle de chambre de réaction (5) au fond de chambre de réaction (3) pouvant être réduite à zéro lors du passage d'une position de réaction, dans laquelle les couches sont déposées sur le substrat, dans une position de nettoyage dans laquelle la chambre de réaction est nettoyée, **caractérisé par** une unité de refroidissement (7) qui est disposée au-dessus du couvercle de chambre de réaction (5) et au moyen de laquelle le couvercle de chambre de réaction (5) est refroidi dans la position de réaction lors du dépôt des couches, la distance de l'unité de refroidissement (16) au couvercle de chambre de réaction (5) augmentant lorsque l'on réduit la distance (H) du couvercle de chambre de réaction (5) au fond de chambre de réaction (3).

2. Dispositif selon la revendication 1, **caractérisé en ce que** l'unité de refroidissement (7) présente une surface de refroidissement (8) s'étendant parallèlement au côté arrière (5'') du couvercle (5).

3. Dispositif selon la revendication 1, **caractérisé en ce que** la surface de refroidissement (8) s'appuie contre le côté arrière (5) du couvercle (5) dans la position de réaction.

4. Dispositif selon l'une des revendications précédentes, **caractérisé en ce que** la surface de refroidissement (8) de l'unité de refroidissement (7) s'étend sensiblement sur tout le côté arrière (5'') du couvercle (5) et s'appuie avec conduction thermique contre le couvercle (5).

5. Dispositif selon l'une des revendications précédentes, **caractérisé en ce que** l'unité de refroidissement (7) forme un corps creux traversé par un liquide de refroidissement.

6. Dispositif selon l'une des revendications précédentes, **caractérisé en ce qu'**un support de fond ou de couvercle (9, 10) peut se déplacer dans une direction verticale à l'intérieur du boîtier de réacteur.

7. Dispositif selon l'une des revendications précédentes, **caractérisé en ce que** des moyens de retenue (11, 12) du support de couvercle (9) s'engagent avec le bord du couvercle (5).

8. Dispositif selon l'une des revendications précédentes, **caractérisé par** une plaque de couvercle (5) en forme de disque circulaire annulaire dont le bord intérieur repose sur des moyens de retenue (12) d'un cylindre intérieur (13) du support de couvercle (9).

9. Dispositif selon l'une ou plusieurs des revendications précédentes, **caractérisé en ce que** le bord extérieur de la plaque de couvercle (5) repose sur des moyens de retenue (11) d'un cylindre extérieur (14) du support de couvercle (9).

10. Dispositif selon l'une ou plusieurs des revendications précédentes, **caractérisé par** des moyens de levage (15) qui sont disposés au-dessus de la chambre de réaction (2) et qui sont destinés à déplacer verticalement le support de couvercle (9).

11. Dispositif selon l'une des revendications précédentes, **caractérisé par** un organe d'admission de gaz (6) qui fait saillie depuis le bas à travers le fond (3) jusque dans la chambre de réaction (2) et qui est doublé au moins partiellement par le cylindre intérieur (13) lorsque le couvercle (5) est dans la position abaissée.

12. Dispositif selon l'une des revendications précédentes, **caractérisé en ce que** le couvercle (5) présente une surface de sortie de gaz d'un organe d'admission de gaz (6), laquelle comporte des ouvertures de sortie de gaz (16) qui sont disposées en pomme de douche.

13. Dispositif selon l'une des revendications précédentes, **caractérisé par** une ouverture de sortie de gaz qui est associée au fond (3) et qui est destinée à un gaz corrosif.
